# EUROPÄISCHE PATENTSCHRIFT

(11) **EP 2 317 833 B1**
(45) Veröffentlichungstag und Bekanntmachung des Hinweises auf die Patenterteilung: **03.01.2018**
(21) Anmeldenummer: 10188154.8
(22) Anmeldetag: 20.10.2010
(51) Int. Cl.: H05K 5/00

(54) **Schaltschrank bzw. Geräteträgeranordnung, insbesondere zur Abgasmessung bei Kraftfahrzeugen**
Switching control cabinet and device holder assembly, in particular for measuring the exhaust gas of motor vehicles
Armoire électrique ou agencement de support d'appareil, notamment pour la mesure des gaz d'échappement dans des véhicules automobiles

(30) Priorität: 30.10.2009 DE 202009014666 U
(43) Veröffentlichungstag der Anmeldung: 04.05.2011
(73) Patentinhaber: MAHA-AIP GmbH & Co. KG, 87490 Haldenwang (DE)
(72) Erfinder: Hartmann, Christian, 87452 Altusried (DE)
(74) Vertreter: MERH-IP Matias Erny Reichl Hoffmann Patentanwälte PartG mbB

(56) Entgegenhaltungen:
- JP-A- 11 020 913
- US-A- 5 443 312
- US-B1- 6 553 818

## Beschreibung

Die vorliegende Erfindung betrifft eine Schaltschrank- bzw. Geräteträgeranordnung, insbesondere zur Abgasmessung bei Kraftfahrzeugen, die einen kompakten Aufbau bei einer zugleich sehr guten Zugänglichkeit im Hinblick auf Wartungsarbeiten aufweist.

In der Fahrzeugindustrie muss das Emissionsverhalten, d. h. die ausgestoßenen Abgase pro Kilometer bzw. pro gefahrene Wegstrecke, erfasst werden. Dies erfolgt auf einem Prüfstand, bei dem ein vorgeschriebener Fahrzyklus nachgefahren wird. Dabei wird das Abgas des Kraftfahrzeugs vor der Analyse seiner Zusammensetzung mit der Umgebungsluft gemischt und der Volumenstrom dieses Gemisches konstant gehalten. Derartige Anlagen werden als CVS-Anlagen (Constant Volume Sampler) bezeichnet.

Das verdünnte Abgas wird anschließend durch mehrere sog. kritische Venturidüsen gesaugt. Da der Volumenstrom durch die Venturidüse von der Temperatur und dem Druck des durchströmenden Mediums abhängt, ist dieser nur dann konstant, wenn die Temperatur und das Druckverhältnis im Eingang der Venturidüse ebenfalls konstant sind. Deswegen ist es vorgeschrieben, die Einlasstemperatur über Wärmetauscher innerhalb vorgegebener Grenzen konstant zu halten. Unmittelbar vor den Venturidüsen sind kleine Probenentnahmedüsen vorgesehen, wodurch ein konstanter Teilvolumenstrom (< 1%) abgezweigt wird. Dieser Teilvolumenstrom wird dann über Messgaspumpen einem Sammelbeutel zugeführt.

Aus den Strömungsparametern lassen sich die Dichte, die Viskosität η, der Volumenstrom sowie die Reynoldszahl Re des Teilgasstromes berechnen. Diese Strömungsdaten dienen der Regelung der Teilvolumenstromentnahme bei sich ändernden Strömungsbedingungen im Abgashauptstrom. Ein sog. Flow-Computer dient zur Berechnung des Volumenstroms durch die Venturidüse, wobei hierzu die gemessene Temperatur und der Druck, sowie die Düsenkonstante berücksichtigt werden. Die zeitliche Integration des erfassten Volumenstroms ergibt dann das Volumen.

Die zu einer CVS-Anlage gehörenden Komponenten werden bislang in einem sogenannten 19"-Schrank installiert, wobei diese genormte Außenmaße und einen vorbestimmten Aufbau im Inneren besitzen. Für Servicezwecke ist es wichtig, dass die im Inneren befindlichen Filter, Düsen und Pumpen usw. frei zugänglich sind, so dass der 19"-Schrank frei im Raum angeordnet werden muss, um dadurch rundum zugänglich zu sein. Dies hat jedoch den Nachteil, dass dadurch eine solche Anlage relativ viel Platz in Anspruch nimmt.

Eine ähnliche Problemstellung ergibt sich im Bereich von Analysegeräteträgern für derartige Kraftfahrzeugprüfstände, bei denen über eine Vielzahl von Ventilen und Druckmindereinrichtungen Prüfgase in den Schrank eingeleitet werden, deren chemische Zusammensetzung anschließend bestimmt wird. Bei diesen Schränken sind hierfür ebenso Messgaspumpen vorgesehen. Auch bei den Analysegeräten ist eine Zugänglichkeit von vorn und von hinten von Vorteil.

US 6 553 818 B1 beschreibt ein Verfahren und eine Vorrichtung, die ein Abgasmesssystem für ein Kraftfahrzeug kalibriert. Das Verfahren umfasst, dass ein Luftfluss zum Abgasmesssystem mit bekannter Durchflussrate zugeführt wird und ein vom Abgasmesssystem ausgegebenes Signal gemessen und gespeichert wird.

Es ist eine Aufgabe der vorliegenden Erfindung eine Schaltschrank- bzw. eine Geräteträgeranordnung, insbesondere zur Abgasmessung bei Kraftfahrzeugen, mit einem möglichst geringen Raumbedarf bei einer zugleich sehr guten Zugänglichkeit, insbesondere im Hinblick auf Wartungsarbeiten, bereitzustellen.

Diese Aufgabe wird erfindungsgemäß durch die Gegenstände des unabhängigen Anspruches gelöst. Vorteilhafte Ausgestaltungen und bevorzugte Ausführungsbeispiele der Erfindung sind in den Unteransprüchen angegeben.

Erfindungsgemäß wird eine Schaltschrank- bzw. eine Geräteträgeranordnung, insbesondere zur Abgasmessung bei Kraftfahrzeugen, bereitgestellt, die einen ersten Schrankteil und einen zweiten Schrankteil umfasst, wobei der erste Schrankteil mit dem zweiten Schrankteil in eine lösbare Verbindung bringbar ist, und der erste Schrankteil für den Verbleib an einem festgelegten Einbauort vorgesehen ist und eine Einlassschnittstelle zur festen Verbindung mit zumindest einer Messgaszuleitung für Messgas und eine Auslassschnittstelle zur Verbindung mit einer Messgasableitung für das Messgas aufweist. Weiterhin sind die beiden Schrankteile mit einer flexiblen Verbindungsleitung verbunden. Die flexible Verbindungsleitung enthält zumindest eine flexible Messgaszuleitung, die sowohl mit der Einlassschnittstelle als auch mit der zumindest einen Messeinrichtung im zweiten Schrankteil zur Untersuchung von zumindest einer Messgaskomponente gasdicht verbunden ist. Weiterhin weist bei einer Schaltschrankanordnung zumindest ein Schrankteil zumindest eine Messgaspumpe auf.

Dieser Aufbau hat den Vorteil eines sehr geringen Raumbedarfs, da aufgrund des teilbaren Schrankaufbaus derjenige Teil der Einbaukomponenten mit einer guten Zugänglichkeit durch eine entsprechende Anordnung bzw. Ausrichtung im Raum Weiterhin von allen Seiten im Service- bzw. Wartungsfall bei gegenüber herkömmlichen Schaltschränken verringerten Abmaßen erreichbar ist, während der andere Teil des Schaltschranks verfahrbar ist und in eine andere Einbauposition, bspw. an eine Rückwand, gebracht werden kann. So sind insbesondere die Venturidüsen von vorne sichtbar und einfach zugänglich für Reinigungs- oder Wartungsarbeiten. Weiterhin bietet der vorliegende Aufbau der Schaltschrank- bzw. Geräteträgeranordnung den Vorteil, dass nunmehr der Auslass der Messgase bspw. an der Seite oder in vertikaler Richtung erfolgen kann.

Weiterhin kann der zweite Schrankteil bewegbar, beispielsweise verschiebbar oder verfahrbar sein und zumindest eine Messeinrichtung zur Untersuchung von zumindest einer Messgaskomponente aufweisen. Dadurch kann insbesondere im Hinblick auf eine CVS-Anlage der zweite Schrankteil samt der zugehörigen Messeinrichtung flexibel angeordnet werden.

Weiterhin kann in der flexiblen Verbindungsleitung eine flexible Messgasrückleitung vorgesehen sein, welche sowohl mit der zumindest einen Messeinrichtung als auch mit der Auslassschnittstelle im zweiten Schrankteil gasdicht verbunden ist.

Weiterhin kann bei einem Schaltschrank der verfahrbare Schrankteil Rollen aufweisen. Dadurch kann dieser besonders einfach an verschiedene Stellen verfahren und dort platziert werden, wobei dafür nur ein recht geringer Kraftaufwand erforderlich ist.

Weiterhin kann bei einer Schaltschrankanordnung die zumindest eine Messeinrichtung des zweiten Schrankteils zur Untersuchung des Messgases im Hinblick auf zumindest eine Komponente aus CO, CO₂, HC sowie NOₓ geeignet sein. Somit können die gesetzlich vorgeschriebenen Anteile der genannten Abgaskomponenten bestimmt werden.

Mittels der Messgaspumpe kann zum einen das Messgas durch den zugehörigen Schrankteil gepumpt werden, und zum anderen kann diese dafür sorgen, dass das Messgas über die flexible Verbindungsleitung in den anderen Schrankteil gepumpt wird, so dass dieses in beiden Schrankteilen zur Verfügung steht.

Weiterhin kann in einer Schaltschrankanordnung der erste Schrankteil zumindest eine Heizung, zumindest einen Wärmetauscher und zumindest eine Venturidüse aufweisen. Mit dieser Konfiguration kann bei einer CVS-Anlage der gesetzlich vorgeschriebene Temperaturbereich für das zu untersuchende Messgas vor dem Eintritt in die kritische Venturidüse einstellt werden.

Weiterhin kann bei einer Schaltschrankanordnung der zweite Schrankteil eine Steuereinrichtung zur Regelung der zumindest einen Venturidüse aufweisen. Die Steuereinrichtung kann insbesondere bei einer CVS-Anlage die Zustandsinformationen des Messgasstroms, die vor dessen Eintritt in die kritische Venturidüse erfasst wurden, für die Steuerung der Vorwärmtemperatur des Messgasstroms mittels der Heizung und des Wärmetauschers sorgen.

Weiterhin kann bei einer Schaltschrankanordnung die flexible Verbindungsleitung ein Datenkabel enthalten. Somit kann ein Informationsaustausch im Hinblick auf die vorstehend erwähnten Messwerte oder die Steuerungs- bzw. Regelungsinformationen zwischen den beteiligten Komponenten in den beiden Schrankteilen realisiert werden.

Weiterhin können bei einer Schaltschrankanordnung die Einlassschnittstelle und die Auslassschnittstelle für das Messgas auf gegenüber liegenden Seiten angeordnet sein. Insbesondere bei der Verwendung der Schaltanordnung zum Aufbau einer CVS-Anlage kann die Auslassschnittstelle auf der linken Seite oder auf der rechten Seite oder auf der Unterseite am jeweiligen Schrankteil angeordnet sein.

Weiterhin können bei einer Schaltschrankanordnung die getrennten Schrankteile über Eck angeordnet sein. Dadurch kann beispielsweise der verfahrbare Schrankteil an einer Rückwand platziert sein, während der nicht-verfahrbare Schrankteil über Eck dazu derart angeordnet wird, so dass die darin enthaltenen Komponenten von beiden Seiten frei zugänglich sind. Weiterhin können bei einer Schrankanordnung die getrennten Schrankteile rückseitig, linksbündig oder rechtsbündig angeordnet sein.

Weiterhin kann bei einer Schaltschrankanordnung der zweite Schrankteil eine Tür aufweisen. So kann die Tür mittels Scharnieren an einer Seite des zweiten Schrankteils mit diesem verbunden sein. Weiterhin kann die Türe einstückig ausgebildet sein. Weiterhin kann die Türe eine Anzeigeeinrichtung aufweisen, die Daten der beteiligten Messgeräte bzw. der Steuereinrichtung darstellen kann.

Vorteilhafte Ausgestaltungen und weitere Details der vorliegenden Erfindung werden im Folgenden anhand verschiedener Ausführungsbeispiele mit Bezug auf schematische Figuren beschrieben.
Fig. 1 zeigt eine perspektivische Ansicht einer Schrankanordnung als CVS-Anlage gemäß der vorliegenden Erfindung, und
Fig. 2 zeigt eine perspektivische Ansicht einer der Schrankanordnung als Analyseeinheit gemäß der vorliegenden Erfindung.

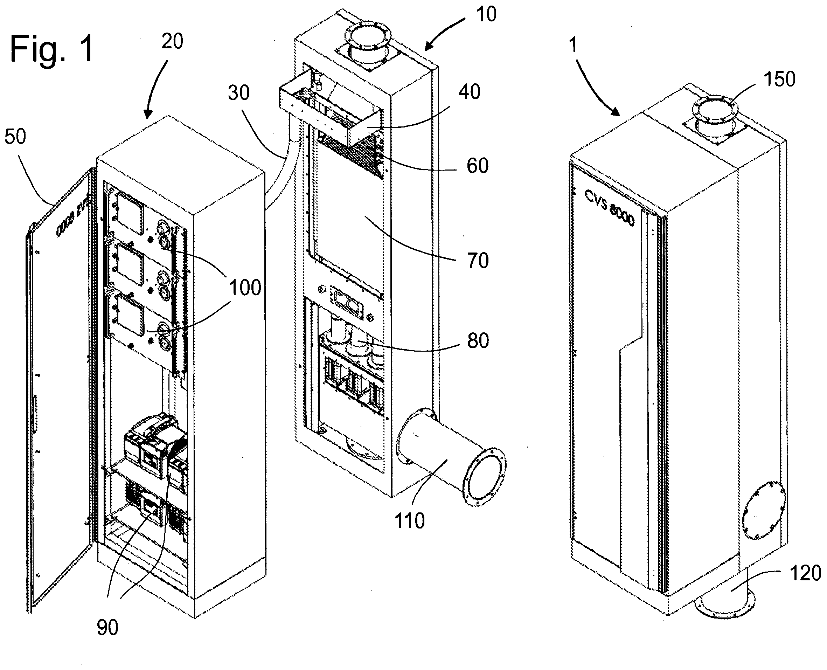

Fig. 1 zeigt eine vorliegende Schrankanordnung 1 als CVS-Anlage, wobei auf der linken Seite die Schrankanordnung für Servicezwecke geöffnet und auf der rechten Seite diese geschlossen ist. Die Schrankanordnung besteht aus einem verfahrbaren Vorderschrank 20 und einem nicht-verfahrbaren Hinterschrank 10.

Der Hinterschrank 10 weist einen Einlassschnittstelle 150 für ein Messgas bspw. von einem Kraftfahrzeugprüfstand, auf, wobei eine feste Verbindung mit einer externen Messgasleitung (nicht dargestellt) in den Hinterschrank 10 erzielt wird. Stromabwärts von der Einlassschnittstelle 150 ist in dem Hinterschrank 10 ein Einschubrahmen 40 angeordnet, an den sich eine Heizung 60 für eine Temperierung des Messgases anschließt. Stromabwärts von der Heizung 60 ist ein Wärmetauscher 70 angeordnet, durch den das temperierte Messgas strömt. Angrenzend an den Wärmetauscher 70 sind in Strömungsrichtung drei kritische Venturidüsen 80 angeordnet. An den Venturidüsen 80 sind eingangsseitig Sensoren für Absolutdruck und Temperatur angeordnet, um unter Berücksichtigung der Venturikalibrierfaktoren den normierten Durchfluss bestimmen zu können.

Ein Teilmassenstrom des temperierten Messgases wird über eine Leitung (nicht dargestellt) im Inneren des Hinterschranks 10 vor den Venturidüsen 80 abgezweigt und in Richtung der Heizung 60 geführt. An dem Einschubrahmen 40 ist eine flexible Verbindungsleitung 30 gasdicht befestigt, so dass der Teilmassenstrom mittels einer in der flexiblen Verbindungsleitung 30 innenliegenden flexiblen Messgaszuleitung (nicht dargestellt) in mehrere Steuer- bzw. Regelgeräte 100 zur Regelung der Temperatur der Heizung 60 im Vorderschrank 10 dient. Die Rückführung des Teilmassenstroms von dem Vorderschrank 20 zum Hinterschrank 10 erfolgt durch den Einsatz von Messgaspumpen 90. Diese pumpen den Teilmassenstrom über eine flexible Messgasrückleitung, die ebenfalls im Inneren der flexiblen Verbindungsleitung 30 angeordnet und mit dem Einschubrahmen 40 gasdicht verbunden ist, in Richtung einer Auslassschnittstelle 110 bzw. 120 für das Messgas aus dem Hinterschrank 10. Der Vorderschrank 20 weist auf einer Seite eine Tür 50 auf, welche über Scharniere mit dem Vorderschrank 20 verbunden ist.

Nach dem Durchströmen der kritischen Venturidüsen 80 wird das Messgas über die Auslassschnittstelle 110 bzw. 120 für Messgas aus dem Hinterschrank 10 geführt. Die Auslassschnittstelle 110 ist dabei auf einer Seite im Bereich der Unterseite des Hinterschranks 10 angeordnet. Je nach Lage des externen Anschlusses für die Weiterleitung des Messgases kann die Auslassschnittstelle 120 auch auf der Unterseite des Hinterschranks 10 in vertikaler Richtung erfolgen.

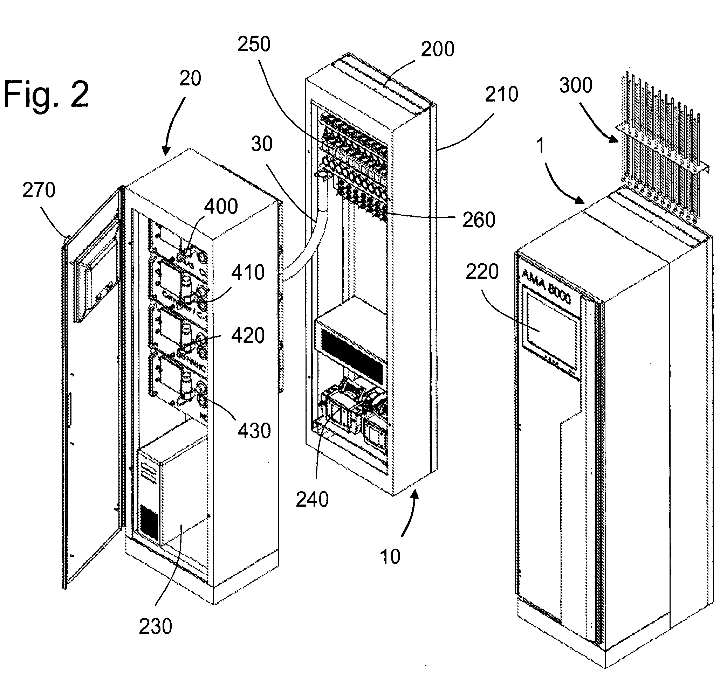

Fig. 2 zeigt eine perspektivische Ansicht einer Schrankanordnung 1 als Analyseeinheit, die eine Vielzahl von Analysegeräte aufweist, welche die bei der Fahrzeugprüfung entnommenen Messgase im Hinblick auf deren quantitative und qualitative Zusammensetzung untersucht. Auf der linken Seite von Fig. 2 ist die Schrankanordnung 1 für Servicezwecke geöffnet, wobei im Hinterschrank 10 eine Vielzahl von Druckminderern 250, mehrere Ventilinseln 260 und Messpumpen 240 angeordnet sind. Die rechte Seite von Fig. 2 zeigt die Schrankanordnung 1 wiederum im geschlossenen Zustand.

Die Schrankanordnung 1 besteht aus einem Vorderschrank 20, der mittels Rollen (nicht dargestellt) verfahrbar ist, und aus einem nicht-verfahrbaren Hinterschrank 10. Der Hinterschrank 10 weist eine Einlassschnittstelle 200 zum Einleiten von mehreren voneinander getrennten Messgasströmen auf, so dass in diesem Beispiel deren Zufuhr mittels einer Vielzahl von nebeneinander angeordnet Rohrleitungen 300 erfolgt, wobei zumindest eine Rohrleitung für die Rückführung des Messgasstroms aus der Analyseeinheit nach dem Ende der Analyse an die Umwelt dient. Die Rohrleitungen 300 sind fest mit der Einlassschnittstelle 200 verbunden (hier explosionsartig dargestellt).

Der Hinterschrank 10 weist auf seiner Rückseite eine abnehmbare Verkleidung 210 auf, welche den gesamten Bereich der Rückseite bedeckt. Das Messgas wird von Messgaspumpen 240 nach dem Eintritt in den Hinterschrank 10 zuerst durch die Druckminderer 250 und dann durch Ventilinseln 260 gepumpt, und anschließend mittels einer flexiblen Verbindungsleitung 30 wiederum in den Vorderschrank 20 geführt. Die flexible Verbindungsleitung 30 weist in ihrem Inneren wiederum eine flexible Messgaszuleitung und eine flexible Messgasrückleitung für den Transport des Messgases auf und ist an ihren Enden mit den zugehörigen Anschlüssen gasdicht verbundent. Die Länge der flexiblen Verbindungsleitung 30 wird derart gewählt, dass eine möglichst flexible Anordnung von Vorderschrank 20 und Hinterschrank 10 möglich ist.

Im Vorderschrank 20 sind die Analysegeräte für die Bestimmung der einzelnen Messgaskomponenten eines Messgasstroms angeordnet, so dient das Messgerät 400 in diesem Beispiel zur Untersuchung des Messgas hinsichtlich CO, das Messgerät 410 zur Untersuchung hinsichtlich CO₂, das Messgerät 420 zur Untersuchung hinsichtlich HC und das Messgerät 430 zur Untersuchung hinsichtlich NOₓ aus dem Abgas des untersuchten Kraftfahrzeugs. Weiterhin ist in dem Vorderschrank 20 ein Rechner 230 angeordnet, der die Messwerte der vorstehend beschriebenen Messgeräte 400-430 einlesen und weiterverarbeiten kann. In der Tür 270 des Vorderschranks 20 ist ein Monitor 220 angeordnet, der mit dem Rechner 230 verbunden ist und zur Visualisierung der analysierten Messwerte aus dem zu untersuchenden Abgas dient, bzw. mittels eines Touch-Screens in der Lage ist, den Prüfablauf bzw. Parameter bzgl. des Prüfvorgangs durch einen Benutzer zu verändern.

Die gezeigten Ausführungsbeispiele sind rein illustrativ und nicht beschränkend auszulegen. An ihnen können zahlreiche Änderungen vorgenommen werden, ohne den Schutzumfang der Ansprüche zu verlassen.

## Patentansprüche

1. Schaltschrank- bzw. Geräteträgeranordnung zur Abgasmessung an Kraftfahrzeugen, umfassend:
- einen ersten Schrankteil (10), und
- einen zweiten Schrankteil (20),
wobei
- der erste Schrankteil (10) mit dem zweiten Schrankteil (20) in eine lösbare Verbindung bringbar ist,
- der erste Schrankteil (10) für den Verbleib an einem festgelegten Einbauort vorgesehen ist und eine Einlassschnittstelle (150, 200) zur festen Verbindung mit zumindest einer Messgaszuleitung für Messgas und eine Auslassschnittstelle (110, 120; 300) zur Verbindung mit einer Messgasableitung für das Messgas aufweist,
**dadurch gekennzeichnet, dass**
- die beiden Schranktelle (10, 20) mit einer flexiblen Verbindungsleitung (30) verbunden sind, wobei
die flexible Verbindungsleitung (30) zumindest eine flexible Messgaszuleitung enthält, die sowohl mit der Einlassschnittstelle (150, 200) als auch mit zumindest einer Messeinrichtung (400, 410, 420, 430) oder Steuer- bzw. Regelgeräten im zweiten Schrankteil (20) zur Untersuchung von zumindest einer Messgaskomponente gasdicht verbunden ist, und wobei zumindest ein
Schrankteil (10, 20) eine Messgaspumpe (90; 240) aufweist, um das Messgas durch den zugehörigen Schrankteil zu pumpen, so daß das Messgas in beiden Schrankteilen zur Verfügung steht.

2. Schaltschrankanordnung nach Anspruch 1, **dadurch gekennzeichnet, dass** der zweite Schrankteil (20) verfahrbar ist und zumindest eine Messeinrichtung (400, 410, 420, 430) zur Untersuchung von zumindest einer Messgaskomponente aufweist.

3. Schaltschrankanordnung nach Anspruch 1 oder 2, **dadurch gekennzeichnet, dass** in der flexiblen Verbindungsleitung (30) eine flexible Messgasrückleitung vorgesehen ist, welche sowohl mit der zumindest einen Messeinrichtung (400, 410, 420, 430) als auch mit der Auslassschnittstelle (110; 120; 300) im zweiten Schrahkteil (20) gasdicht verbunden ist.

4. Schaltschrankanordnung nach Anspruch 2 oder 3, **dadurch gekennzeichnet, dass** der verfahrbare Schrankteil (10, 20) Rollen aufweist.

5. Schaltschrankanordnung nach zumindest einem der Ansprüche 2-4, **dadurch gekennzeichnet, dass** die zumindest eine Messeinrichtung (400, 410, 420, 430) des zweiten Schrankteils (20) zur Untersuchung des Messgases im Hinblick auf zumindest eine Komponente aus CO, CO₂, HC sowie NOₓ geeignet ist.

6. Schaltschrankanordnung nach zumindest einem der Ansprüche 1-5, **dadurch gekennzeichnet, dass** zumindest ein Schrankteil (10, 20) zumindest eine Messgaspumpe (90; 240) aufweist.

7. Schaltschrankanordnung nach zumindest einem der Ansprüche 1-6, **dadurch gekennzeichnet, dass** der erste Schrankteil (10) zumindest eine Heizung (60), zumindest einen Wärmetauscher (70) und zumindest eine Venturidüse (80) aufweist.

8. Schaltschrankanordnung nach zumindest einem der Ansprüche 1-7, **dadurch gekennzeichnet, dass** der zweite Schrankteil (20) eine Steuereinrichtung (90, 100) zur Regelung der zumindest einen Venturidüse (80) aufweist.

9. Schaltschrankanordnung nach zumindest einem der Ansprüche 1-8, **dadurch gekennzeichnet, dass** die flexible Verbindungsleitung (30) ein Datenkabel enthält.

10. Schaltschrankanordnung nach zumindest einem der Ansprüche 1-9, **dadurch gekennzeichnet, dass** die Einlassschnittstelle (150, 200) und die Auslassschnittstelle (110; 120) für das Messgas auf gegenüber liegenden Seiten angeordnet sind.

11. Schaltschrankanordnung nach zumindest einem der Ansprüche 1-10, **dadurch gekennzeichnet, dass** die getrennten Schrankteile (10, 20) über Eck angeordnet sind.

12. Schaltschrankanordnung nach zumindest einem der Ansprüche 1-11, **dadurch gekennzeichnet, dass** der zweite Schrankteil (20) eine Tür (50; 270) aufweist.

## Claims

1. A switching cabinet and equipment support arrangement for measuring exhaust gas of motor vehicles, comprising:
- a first cabinet portion (10), and
- a second cabinet portion (20),
wherein
- said first cabinet portion (10) can be detachably connected to said second cabinet portion (20),
- said first cabinet portion (10) is configured to remain at a fixed installation location and comprises an inlet interface (150, 200) for fixedly connecting to at least one sample gas supply line for sample gas, and an outlet interface (110, 120; 300) for connecting to a sample gas discharge line for the sample gas, and
- said two cabinet portions (10, 20) are connected to a flexible connecting line (30), wherein
said flexible connecting line (30) comprises at least one flexible sample gas supply line, which is gas-tightly connected to both said inlet interface (150, 200) and at least one measuring device (400, 410, 420, 430) or control and regulation equipment in said second cabinet portion (20) for analyzing at least one sample gas component, and wherein
at least one cabinet portion (10, 20) comprises a sample gas pump (90; 240) for pumping the sample gas through the respective cabinet portion such that the sample gas is available in both cabinet portions.

2. The switching cabinet arrangement according to claim 1, **characterized in that** said second cabinet portion (20) is displaceable and comprises at least one measuring device (400, 410, 420, 430) for analyzing at least one sample gas component.

3. The switching cabinet arrangement according to claim 1 or 2, **characterized in that**, in said flexible connecting line (30), a flexible sample gas return line is provided, which is gas-tightly connected to both said at least one measuring device (400, 410, 420, 430) and said outlet interface (110, 120, 300) in said second cabinet portion (20).

4. The switching cabinet arrangement according to claim 2 or 3, **characterized in that** the displaceable cabinet portion (10, 20) includes rollers.

5. The switching cabinet arrangement according to at least one of the claims 2-4, **characterized in that** said at least one measuring device (400, 410, 420, 430) of said second cabinet portion (20) is adapted to analyze the sample gas with respect to at least one component of CO, CO₂, HC, and NOₓ.

6. The switching cabinet arrangement according to at least one of the claims 1-5, **characterized in that** at least one cabinet portion (10, 20) includes at least one sample gas pump (90; 240).

7. The switching cabinet arrangement according to at least one of the claims 1-6, **characterized in that** said first cabinet portion (10) includes at least one heater (60), at least one heat exchanger (70), and at least one Venturi nozzle (80).

8. The switching cabinet arrangement according to at least one of the claims 1-7, **characterized in that** said second cabinet portion (20) has a control device (90, 100) for controlling said at least one Venturi nozzle (80).

9. The switching cabinet arrangement according to at least one of the claims 1-8, **characterized in that** said flexible connecting line (30) includes a data cable.

10. The switching cabinet arrangement according to at least one of the claims 1-9, **characterized in that** said inlet interface (150, 200) and said outlet interface (110, 120) for the sample gas are arranged on opposite sides.

11. The switching cabinet arrangement according to at least one of the claims 1-10, **characterized in that** the separate cabinet portions (10, 20) are arranged at an angle.

12. The switching cabinet arrangement according to at least one of the claims 1-11, **characterized in that** said second cabinet portion (20) includes a door (50; 270).

## Revendications

1. Agencement d'armoire électrique ou de support d'appareil pour mesurer des gaz d'échappement dans des véhicules automobiles, comportant :
- une première partie d'armoire (10), et
- une seconde partie d'armoire (20),
dans lequel
- la première partie d'armoire (10) est susceptible d'être amenée en liaison détachable avec la seconde partie d'armoire (20),
- la première partie d'armoire (10) est prévue pour rester à un endroit d'installation immobilisé et présente une interface d'entrée (150, 200) pour la liaison ferme avec au moins une conduite d'alimentation en gaz à mesurer et au moins une interface de sortie (110, 120 ; 300) pour la liaison avec une conduite d'évacuation de gaz à mesurer ;
**caractérisé en ce que**
- les deux parties d'armoire (10, 20) sont reliées par une conduite de liaison flexible (30),
la conduite de liaison flexible (30) comprenant au moins une conduite d'alimentation flexible pour les gaz à mesurer, qui est reliée de façon étanche aux gaz aussi bien à l'interface d'entrée (150, 200) qu'à au moins un dispositif de mesure (400, 410, 420, 430) ou à des appareils de commande ou de régulation dans la seconde partie d'armoire (20) pour analyser au moins une composante des gaz à mesurer, et
au moins une partie d'armoire (10, 20) comprenant une pompe de gaz à mesurer (90 ; 240) pour pomper les gaz à mesurer à travers la partie d'armoire associée, de sorte que les gaz à mesurer sont disponibles dans les deux parties d'armoire.

2. Agencement d'armoire électrique selon la revendication 1, **caractérisé en ce que** la seconde partie d'armoire (20) est déplaçable et comprend au moins un dispositif de mesure (400, 410, 420, 430) pour analyser au moins une composante de gaz à mesurer.

3. Agencement d'armoire électrique selon la revendication 1 ou 2, **caractérisé en ce que** dans la conduite de liaison flexible (30) est prévue une conduite de retour flexible pour les gaz à mesurer, qui est reliée de façon étanche aux gaz aussi bien audit au moins un dispositif de mesure (400, 410, 420, 430) qu'à l'interface de sortie (110 ; 120 ; 300) dans la seconde partie d'armoire (20).

4. Agencement d'armoire électrique selon la revendication 2 ou 3, **caractérisé en ce que** la partie d'armoire déplaçable (10, 20) comprend des rouleaux.

5. Agencement d'armoire électrique selon l'une au moins des revendications 2 à 4, **caractérisé en ce que** ledit au moins un dispositif de mesure (400, 410, 420, 430) de la seconde partie d'armoire (20) convient pour analyser les gaz à mesurer à l'égard d'au moins une composante parmi le CO, CO₂, HC et NOₓ.

6. Agencement d'armoire électrique selon l'une au moins des revendications 1 à 5, **caractérisé en ce qu'**au moins une partie d'armoire (10, 20) comprend au moins une pompe à gaz à mesurer (90 ; 240).

7. Agencement d'armoire électrique selon l'une au moins des revendications 1 à 6, **caractérisé en ce que** la première partie d'armoire (10) comprend au moins un chauffage (60), au moins un échangeur de chaleur (70) et au moins un tube de Venturi (80).

8. Agencement d'armoire électrique selon l'une au moins des revendications 1 à 7, **caractérisé en ce que** la seconde partie d'armoire (20) comprend un dispositif de commande (90, 100) pour réguler ledit au moins un tube de Venturi (80).

9. Agencement d'armoire électrique selon l'une au moins des revendications 1 à 8, **caractérisé en ce que** la conduite de liaison flexible (30) comprend au moins un câble de données.

10. Agencement d'armoire électrique selon l'une au moins des revendications 1 à 9, **caractérisé en ce que** l'interface d'entrée (150, 200) et l'interface de sortie (110 ; 120) pour les gaz à mesurer sont agencées sur des côtés opposés.

11. Agencement d'armoire électrique selon l'une au moins des revendications 1 à 10, **caractérisé en ce que** les parties d'armoire séparées (10, 20) sont agencées angulairement.

12. Agencement d'armoire électrique selon l'une au moins des revendications 1 à 11, **caractérisé en ce que** la seconde partie d'armoire (20) comprend une porte (50 ; 270).
